# FASCICULE DE BREVET EUROPEEN

(11) **EP 4 205 177 B1**
(45) Date de publication et mention de la délivrance du brevet: **23.10.2024**
(21) Numéro de dépôt: 21758115.6
(22) Date de dépôt: 10.08.2021
(51) Int. Cl.: H01L 27/15, H01L 33/00, H01L 33/08, H01L 33/18

(54) **PROCÉDÉ DE FABRICATION D'UN DISPOSITIF OPTOÉLECTRONIQUE**
VERFAHREN ZUR HERSTELLUNG EINER OPTOELEKTRONISCHEN VORRICHTUNG
METHOD OF MANUFACTURING AN OPTOELECTRONIC DEVICE

(30) Priorité: 31.08.2020 FR 2008838
(43) Date de publication de la demande: 05.07.2023
(73) Titulaire: Aledia, 38130 Echirolles (FR)
(72) Inventeur: HUGON, Xavier, 38470 TÊCHE (FR); POURQUIER, Eric, 38000 GRENOBLE (FR); MAYER, Frédéric, 38500 VOIRON (FR); LACAVE, Thomas, 38000 GRENOBLE (FR); GIBERT, Philippe, 38960 ST ETIENNE DE CROSSEY (FR); REBAUD, Mickaël, 38000 GRENOBLE (FR); PETITPREZ, Emmanuel, 38000 GRENOBLE (FR)
(74) Mandataire: Hautier IP
(86) Numéro de dépôt international: PCT/EP2021/072310
(87) Numéro de publication internationale: WO 2022/043053

(56) Documents cités:
- EP-A1- 2 491 591
- EP-B1- 2 491 591
- WO-A1-2011/020959
- US-A1- 2015 179 877
- US-A1- 2016 172 535
- US-A1- 2017 092 719
- US-A1- 2019 198 485

## Description

### DOMAINE TECHNIQUE DE L'INVENTION

L'invention concerne le domaine des technologies des semi-conducteurs. Elle trouve pour application particulièrement avantageuse la fabrication de dispositifs optoélectroniques comprenant des structures tridimensionnelles, par exemple des diodes électroluminescentes à base de fils ou de nanofils semi-conducteurs.

### ETAT DE LA TECHNIQUE

Les architectures dites 3D de dispositifs microélectroniques et optoélectroniques basées sur des réseaux de structures semi-conductrices tridimensionnelles, telles que des nanofils ou des microfils, sont considérées comme des alternatives prometteuses aux architectures classiques basées sur des structures semi-conductrices bidimensionnelles, telles que des couches planes.

De tels dispositifs à architecture 3D peuvent présenter une efficacité globale améliorée. Des réseaux ordonnés de nanofils à base d'un matériau semi-conducteur tel que le GaN, ou plus généralement à base d'un matériau à gap direct pour l'optoélectronique, présentent souvent une qualité cristalline supérieure à celle d'une couche plane à base du même matériau. Cela permet par exemple d'améliorer l'émission de lumière d'un dispositif optoélectronique tel qu'une diode électroluminescente à architecture 3D (LED 3D). Les propriétés optiques de tels réseaux permettent également d'améliorer l'extraction de la lumière.

La fabrication de dispositifs optoélectroniques à architecture 3D fonctionnels nécessite de structurer les réseaux ordonnés de structures 3D, notamment pour définir des zones de contact du dispositif. Ces réseaux ordonnés de structures 3D peuvent être également reliés à une électronique de pilotage. Généralement, l'électronique de pilotage d'une LED 3D est reportée au niveau d'une face arrière du ou des réseaux de nanofils. Il est alors nécessaire de créer une zone d'accès ou une ouverture à travers le réseau de nanofils pour dégager une zone de contact de l'électronique de pilotage, usuellement appelée « pad » ou « CMOS pad » pour une électronique de pilotage à base de transistors CMOS (transistors Complémentaires de type Métal/Oxyde/Semi-conducteur).

Plusieurs solutions connues permettent de former une zone dépourvue de structures 3D.

Ainsi, une solution consiste à faire croître localement les réseaux de structures 3D au niveau des zones d'émission de la LED 3D, en masquant les zones où les structures 3D sont indésirables, typiquement les zones de contact destinées à contacter l'électronique de pilotage du dispositif. Une telle solution entraîne souvent une inhomogénéité et/ou des discontinuités dans le réseau de structures 3D, généralement dues à des perturbations de la croissance aux bords des zones masquées. Cela affecte les performances des dispositifs optoélectroniques 3D.

Une autre solution divulguée dans le document EP 2936571 A1 consiste à faire croître les structures 3D de façon homogène sur toute la surface de la plaquette ou « wafer », puis à les retirer des zones où celles-ci sont indésirables. Le retrait des structures 3D peut se faire par gravure localisée ou via une action mécanique par exemple. Cela induit généralement des problèmes de rugosité néfastes dans le procédé de fabrication des LED 3D. La reproductibilité du procédé est dégradée. US 2017/092719 A1 et WO 2011/020959 A1 divulguent des solutions similaires avec retrait par gravure localisée ou action mécanique. EP 2 491 591 A1 divulgue un procédé d'application localisée de LEDs 3D sur un support de contrôle, au cours duquel les LEDs sont transférées "pleine plaque", leur substrat de croissance est enlevé, et les LEDs situées hors des régions désirées sont enlevées par gravure.

La présente invention vise à pallier au moins partiellement les inconvénients mentionnés ci-dessus.

En particulier, un objet de la présente invention est de proposer un procédé de fabrication d'un dispositif optoélectronique 3D présentant une reproductibilité améliorée.

Un autre objet de l'invention est de proposer un procédé de fabrication d'un dispositif optoélectronique 3D permettant de dégager une zone de contact destinée à contacter une électronique de pilotage du dispositif.

Les autres objets, caractéristiques et avantages de la présente invention apparaîtront à l'examen de la description suivante et des dessins d'accompagnement. Il est entendu que d'autres avantages peuvent être incorporés.

### RESUME DE L'INVENTION

Pour atteindre les objectifs mentionnés ci-dessus, un premier aspect de l'invention concerne un procédé de fabrication d'un dispositif optoélectronique comprenant au moins une première zone dépourvue de structures semi-conductrices tridimensionnelles (3D) et au moins une deuxième zone pourvue de structures semi-conductrices tridimensionnelles (3D). Ce procédé comprend les étapes suivantes :
- Une fourniture d'un support portant sur un plan basal une pluralité de structures semi-conductrices tridimensionnelles, lesdites structures présentant chacune une base tournée vers un premier côté, également appelé face arrière, et un sommet opposé à la base, tourné vers un deuxième côté, également appelé face avant, opposé au premier côté,
- Une formation, à partir du premier côté, d'une portion sacrificielle sous les bases d'un premier ensemble de structures 3D de la pluralité de structures semi-conductrices tridimensionnelles,
- Une formation d'une portion barrière autour de la portion sacrificielle, ladite portion barrière présentant une paroi basale s'étendant sous la portion sacrificielle, et une paroi latérale s'étendant en bordure de la portion sacrificielle, ladite paroi latérale séparant, en projection selon une direction normale au plan basal, le premier ensemble de structures 3D d'un deuxième ensemble de structures 3D de la pluralité de structures semi-conductrices tridimensionnelles,
- Une formation, à partir du deuxième côté, d'une tranchée d'accès jusqu'à la portion sacrificielle, ladite tranchée d'accès s'étendant de façon continue le long de la paroi latérale de la portion barrière, en projection selon la direction normale au plan basal,
- Une gravure de la portion sacrificielle à partir de la tranchée d'accès,
- Un enlèvement du premier ensemble de structures 3D, de sorte à définir l'au moins une première zone du dispositif.

Ainsi, la formation de la tranchée d'accès et la gravure de la portion sacrificielle sous le premier ensemble de structures 3D permettent de désolidariser le premier ensemble du dispositif sans qu'il soit nécessaire de graver les structures 3D. Cela supprime les problèmes de rugosité liés à la gravure des structures 3D mise en oeuvre dans les solutions connues. Le retrait des structures 3D du premier ensemble est en outre facilité. La portion sacrificielle est typiquement enterrée à la base des structures 3D à retirer. La tranchée d'accès permet typiquement de détourer l'ensemble de structures 3D à retirer, et d'accéder à la portion sacrificielle.

La portion barrière permet en outre de confiner la gravure au niveau de la portion sacrificielle. Cela permet d'éviter une altération du support portant les structures 3D du deuxième ensemble. Cette portion barrière comprend une paroi basale et une paroi latérale. Elle peut présenter une forme de cuvette. Son extension selon le plan basal et suivant la normale au plan basal permet d'arrêter la gravure suivant deux directions, en profondeur et latéralement. Sa forme est avantageusement concave vue du deuxième côté. La paroi latérale est de préférence sensiblement normale à la paroi basale. Cette portion barrière est de préférence continue, la paroi latérale et la paroi basale étant raccordées. Avantageusement, ces parois ne sont pas ajourées.

La paroi basale permet de stopper la gravure selon la direction normale au plan basal. Elle forme une protection pour des éléments sous-jacents, par exemple une électronique de pilotage.

La paroi latérale permet de stopper la gravure selon une direction parallèle au plan basal. Elle forme une protection pour des éléments adjacents, par exemple des motifs de contact des structures 3D du deuxième ensemble.

L'au moins une première zone dépourvue de structures 3D ainsi créée peut avantageusement permettre d'accéder à un pad de contact d'une électronique de pilotage du dispositif, de façon localisée et sans altération des éléments environnants du dispositif.

De façon préférée mais non limitative, le procédé comprend en outre, avant formation de la tranchée d'accès, une formation d'une zone de contact, également appelée pad de contact, sous les bases du premier ensemble de structures 3D, et sous la portion sacrificielle. Un tel pad de contact est typiquement destiné à contacter une électronique de pilotage du dispositif.

Selon un exemple, la portion sacrificielle est à base d'un matériau métallique et la portion barrière est à base d'un matériau diélectrique. La portion sacrificielle peut être formée à partir d'une première couche métallique correspondant à un premier niveau M1 du dispositif. La portion barrière peut être formée à partir d'une couche diélectrique enrobant la portion sacrificielle. Le pad de contact peut être formé à partir d'une deuxième couche métallique correspondant à un deuxième niveau M2 du dispositif. Le pad de contact se trouve ici sous la portion barrière, typiquement sous la paroi basale. Cela permet de protéger le pad de contact lors du retrait du premier ensemble de structures 3D.

Selon un exemple alternatif, la portion sacrificielle est à base d'un matériau diélectrique et la portion barrière est à base d'un matériau métallique. La portion sacrificielle peut être formée à partir de la couche diélectrique. La portion barrière peut être formée à partir de la deuxième couche métallique correspondant au deuxième niveau M2 du dispositif. Une gravure sélective du matériau diélectrique vis-à-vis du matériau métallique permet d'exposer la paroi basale de la portion barrière en un matériau métallique. Le pad de contact peut dès lors être directement formé par la paroi basale de la portion barrière. Le nombre d'étapes de procédé permettant de former un pad de contact est ainsi réduit.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre un réseau de structures 3D surmontant des pads de contact enterrés selon une problématique de la présente invention.
Les figures 2A à 2F illustrent en coupe des étapes d'un procédé de réalisation d'un dispositif optoélectronique selon un premier mode de réalisation de la présente invention.
Les figures 2G et 2H illustrent des variantes des étapes respectivement illustrées aux figures 2E et 2F.
Les figures 2I à 2P illustrent des étapes d'un procédé de réalisation d'un dispositif optoélectronique selon le premier mode de réalisation de la présente invention.
Les figures 2Q à 2V illustrent des variantes des étapes respectivement illustrées aux figures 2M à 2P.
Les figures 3A à 3N illustrent des étapes d'un procédé de réalisation d'un dispositif optoélectronique selon un deuxième mode de réalisation de la présente invention.
Les figures 3O à 3R illustrent des variantes des étapes respectivement illustrées aux figures 3J à 3N.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différents éléments du dispositif optoélectronique ne sont pas forcément représentatives de la réalité.

### DESCRIPTION DÉTAILLÉE

Avant d'entamer une revue détaillée de modes de réalisation de l'invention, il est rappelé que l'invention comprend notamment les caractéristiques optionnelles ci-après pouvant être utilisées en association ou alternativement.

Selon un exemple, la gravure de la portion sacrificielle présente une sélectivité de gravure S_{30:50} du matériau de la portion sacrificielle vis-à-vis du matériau de la portion barrière supérieure ou égale à 5:1. Une telle gravure sélective permet de préserver la portion barrière à l'issue de la gravure de la portion sacrificielle.

Selon un exemple, la formation de la tranchée d'accès est effectuée par gravure anisotrope principalement dirigée selon la direction z normale au plan basal xy. Cela permet de détourer latéralement le premier ensemble de structures.

Selon un exemple, la gravure de la portion sacrificielle est une gravure isotrope. Cela permet de séparer le premier ensemble de structures vis-à-vis de la portion barrière sous-jacente.

Selon un exemple, la tranchée d'accès est formée entre les structures du premier ensemble et la paroi latérale de la portion barrière, en projection selon la direction z normale au plan basal xy. Cela permet d'éviter de graver des structures du premier ensemble. La formation de la tranchée d'accès est facilitée.

Selon un exemple, le procédé comprend en outre, avant formation de la tranchée d'accès, une formation d'une zone de contact sous les bases du premier ensemble de structures 3D, ladite zone de contact étant destinée à contacter une électronique de pilotage du dispositif.

Selon un exemple, le procédé comprend en outre, avant formation de la tranchée d'accès, un assemblage d'une électronique de pilotage du dispositif au niveau de la zone de contact. Cela permet d'assembler l'électronique de pilotage, typiquement une électronique à base de transistors CMOS, avant retrait du premier ensemble de structures 3D. Un procédé standard d'assemblage Cuivre-Cuivre peut ainsi être avantageusement utilisé. Cela permet de simplifier le procédé de fabrication du système comprenant le dispositif optoélectronique et son électronique de pilotage. Cela permet de diminuer les coûts de fabrication d'un tel système.

Selon un exemple, l'électronique de pilotage est à base de transistors en couches minces TFT (*Thin-film transistor* en anglais). Selon un exemple, les transistors TFT sont formés selon une technologie dite IGZO (*Indium gallium zinc oxide* en anglais).

Selon un exemple, la portion sacrificielle est en un matériau métallique et la portion barrière est en un matériau diélectrique.

Selon un exemple, le procédé comprend :
- Un dépôt à partir du premier côté d'une première couche métallique correspondant à un premier niveau, puis
- Une gravure de ladite première couche métallique à partir du premier côté, configurée pour définir la portion sacrificielle dans la première couche métallique,
- Un dépôt à partir du premier côté d'une couche diélectrique, configuré pour encapsuler la portion sacrificielle et former la portion barrière.

Selon un exemple, le procédé comprend :
- Avant assemblage de l'électronique de pilotage, un dépôt à partir du premier côté d'une deuxième couche métallique correspondant à un deuxième niveau, sur la couche diélectrique, puis
- Une gravure de ladite deuxième couche métallique à partir du premier côté, configurée pour définir la zone de contact dans la deuxième couche métallique, et
- Après assemblage de l'électronique de pilotage et enlèvement du premier ensemble de structures 3D, une gravure de la portion barrière diélectrique, à partir du deuxième côté, configurée pour exposer une face de la zone de contact ainsi définie, en regard du deuxième côté.

Selon un exemple, la portion sacrificielle est en un matériau diélectrique et la portion barrière est en un matériau métallique.

Selon un exemple, le procédé comprend :
- Un dépôt à partir du premier côté d'une couche diélectrique, de manière à ce qu'une partie de ladite couche diélectrique située sous le premier ensemble de structures 3D forme la portion sacrificielle,
- Une gravure de la couche diélectrique en bordure du premier ensemble de structures 3D, en projection selon une direction z normale au plan basal xy, suivie d'un dépôt métallique, configurés pour former la paroi latérale de la portion barrière,
- Un dépôt à partir du premier côté d'une deuxième couche métallique correspondant à un deuxième niveau, sur la partie de la couche diélectrique formant la portion sacrificielle et en affleurement de la paroi latérale,
- Une gravure de ladite deuxième couche métallique à partir du premier côté, configurée pour définir la paroi basale de la portion barrière dans la deuxième couche métallique et au contact de la paroi latérale.

Selon un exemple, la zone de contact est formée directement par la paroi basale de la portion barrière.

Selon un exemple, la partie de la couche diélectrique formant la portion sacrificielle est structurée avant dépôt de la deuxième couche métallique, de façon à former des marques d'alignement en saillie de la paroi basale de la portion barrière. Ces marques d'alignement permettent par exemple de faciliter une formation ultérieure d'un module convertisseur de couleur. Plus généralement les marques d'alignement permettent d'effectuer des opérations technologiques en face avant en s'alignant précisément sur les repères des structures assemblées en face arrière, typiquement les repères d'une plaque CMOS.

Selon un exemple, le procédé comprend en outre la formation d'un module convertisseur de couleur au niveau des structures du deuxième ensemble.

Selon un exemple, la formation du module convertisseur de couleur est effectuée avant l'enlèvement du premier ensemble de structures 3D.

Selon un exemple, la formation du module convertisseur de couleur est effectuée après l'enlèvement du premier ensemble de structures 3D.

Selon un exemple, la zone de contact est protégée par une couche de protection durant la formation du module convertisseur de couleur.

Selon un exemple, le procédé de fabrication comprend la réalisation d'une zone de contact, ou pad, d'un dispositif optoélectronique comprenant une pluralité de structures semi-conductrices tridimensionnelles (3D). Les structures 3D présentent typiquement chacune une base tournée vers une face arrière et un sommet opposé à la base, tourné vers une face avant. Le pad est destiné à contacter une électronique de pilotage du dispositif. Il s'étend typiquement le long d'un plan basal sous-jacent aux bases des structures 3D.

Avantageusement, le procédé comprend :
- Une fourniture de la pluralité de structures semi-conductrices tridimensionnelles,
- Un dépôt d'une première couche métallique sur un premier niveau M1 en face arrière, en regard des bases,
- Une formation d'une portion sacrificielle sous les bases d'un premier ensemble de structures 3D,
- Une formation de motifs de contacts à partir de la première couche métallique sous les bases d'un deuxième ensemble de structures 3D,
- Un dépôt d'une deuxième couche métallique sur un deuxième niveau M2 distinct du premier niveau M1,
- Une formation d'une portion barrière autour de la portion sacrificielle, ladite portion barrière présentant un contour fermé sous et en bordure de la portion sacrificielle, de sorte à former une cuvette accueillant la portion sacrificielle sous le premier ensemble de structures 3D,
- Une gravure de la portion sacrificielle, depuis la face avant du dispositif,
- Un retrait du premier ensemble de structures 3D, de sorte à définir une zone d'accès vers la deuxième couche métallique,
- Une exposition d'une région de la deuxième couche métallique à partir de la zone d'accès, ladite région formant le pad.

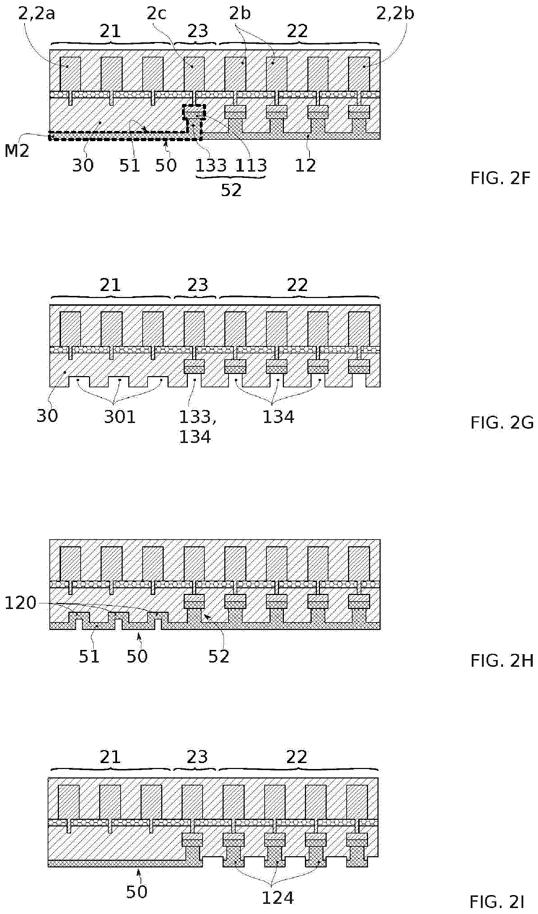

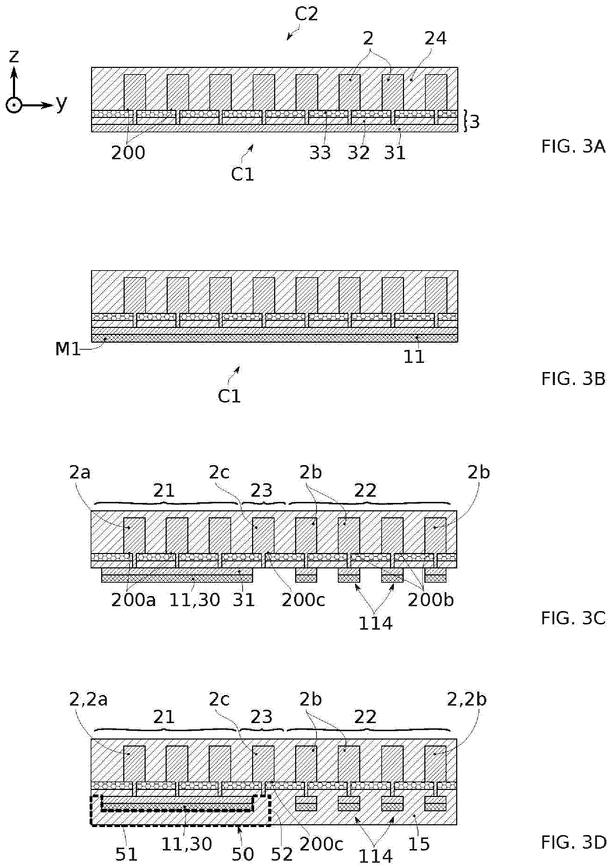

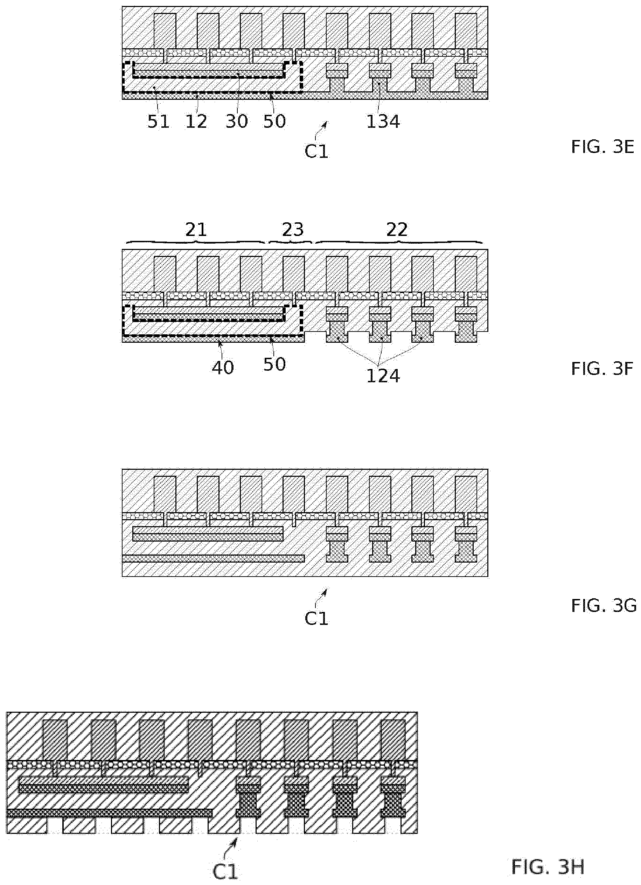

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention. Par exemple, les marques d'alignement formées dans le métal M2 et illustrées aux figures 2G, 2H pour le premier mode de réalisation de l'invention peuvent également être envisagées en variante dans le deuxième mode de réalisation de l'invention illustré aux figures 3D, 3E.

Dans la présente invention, le procédé de fabrication est en particulier dédié à la fabrication de LED présentant une architecture 3D (3D LED).

L'invention peut être mise en oeuvre plus largement pour différents dispositifs optoélectroniques ou microélectroniques à architecture 3D.

L'invention peut donc être également mise en oeuvre dans le cadre de dispositifs laser ou photovoltaïque, ou encore dans le cadre de dispositifs comprenant des transistors ou des mémoires.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément.

Les étapes du procédé telles que revendiquées s'entendent au sens large et ne sont pas nécessairement successives, sauf indication. Elles peuvent éventuellement être réalisées simultanément, ou encore en plusieurs sous-étapes.

Dans la présente demande de brevet, le premier côté correspond typiquement à une face arrière du dispositif, et le deuxième côté correspond typiquement à une face avant du dispositif. La face arrière désigne ainsi plutôt le côté (C1 sur les dessins) à partir duquel sont effectuées les étapes de procédé. De même, la face avant désigne ainsi plutôt le côté (C2 sur les dessins) à partir duquel sont effectuées les étapes de procédé.

Dans la présente demande de brevet, les termes « diode électroluminescente », « LED » ou simplement « diode » sont employés en synonymes. Une « LED » peut également s'entendre d'une « micro-LED ».

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une couche à base de nitrure de gallium (GaN) peut par exemple comprendre du nitrure de gallium (GaN ou GaN-i) ou du nitrure de gallium dopé (GaN-p, GaN-n). Une région active à base de nitrure de gallium-indium (InGaN) peut par exemple comprendre du nitrure de gallium-aluminium (AIGaN) ou du nitrure de gallium avec différentes teneurs en aluminium et en indium (GalnAIN).

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée S_{A:B}.

Un repère, de préférence orthonormé, comprenant les axes x, y, z est représenté sur certaines figures annexées. Le plan basal s'étend selon un plan xy de ce repère.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan basal xy du substrat. Ainsi, une couche métallique présente typiquement une épaisseur selon z, et une LED présente une hauteur selon z. Les termes relatifs « sous », « sous-jacent » se réfèrent à des positions prises selon la direction z.

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

Afin de déterminer si un pad de contact d'un dispositif à base de structures 3D a été fabriqué ou dégagé selon le procédé décrit dans cette invention, une analyse par microscopie électronique à balayage (MEB) ou par microscopie électronique à transmission (MET) peut être effectuée.

En particulier, une observation en coupe transversale sur le pad de contact peut déterminer si ce pad présente une géométrie en cuvette, ou si les flancs surmontant le pad portent l'empreinte d'une cuvette.

Un autre résultat caractéristique de la mise en oeuvre du procédé selon l'invention est l'obtention d'un pad présentant une surface préservée en bordure d'un ensemble de structures 3D homogène et préservé.

La combinaison de ces caractéristiques géométriques et physiques peut être une indication sérieuse de l'utilisation du procédé tel que décrit dans la présente invention.

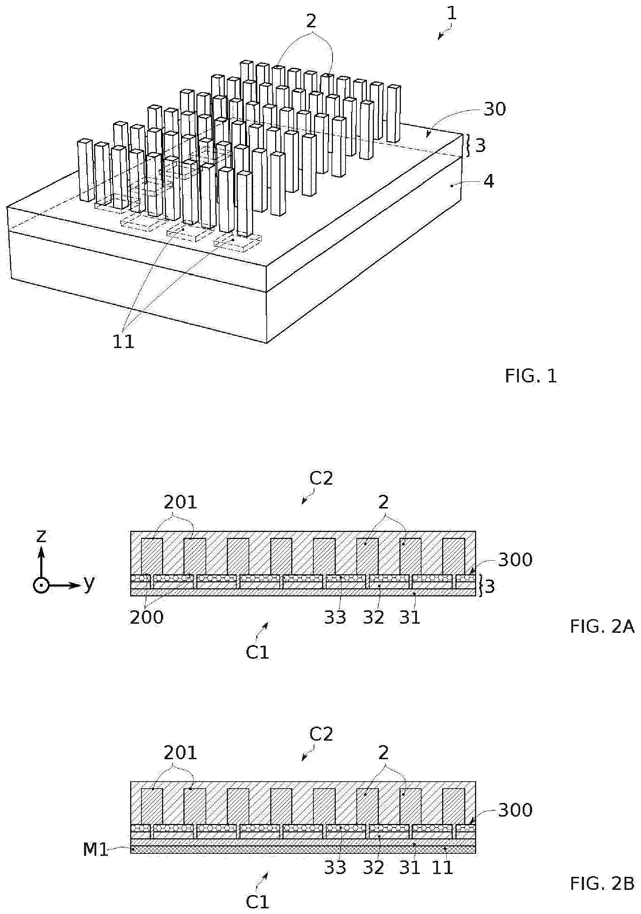

La figure 1 illustre une problématique que le procédé selon l'invention permet de résoudre. Pour obtenir un dispositif 1 à base de structures 3D 2 régulièrement réparties et homogènes, il est préférable de faire croître les structures 3D 2 sur toute la surface 30 du substrat 3. Il est dès lors généralement nécessaire de réaliser des ouvertures dans le réseau de structures 3D 2, de manière à permettre un accès vers des zones enterrées sous les structures 3D 2, par exemple des zones de contact 40 du dispositif 1. Certaines structures 3D doivent ainsi être retirées sans détériorer les autres structures environnantes, en particulier les structures 3D adjacentes et les zones de contact sous-jacentes.

Dans les exemples suivants, les structures 3D sont des nanofils 2 semiconducteurs. Il est entendu que le procédé convient parfaitement à l'enlèvement d'autres types de structures 3D, par exemple et de façon non limitative : des pyramides, des ailettes. Pour enlever ces structures 3D, un principe de l'invention est de former une portion sacrificielle sous les structures 3D à enlever et une portion barrière sous et en bordure de la portion sacrificielle. Une gravure de la portion sacrificielle via une tranchée d'accès permet dès lors de désolidariser les structures 3D à enlever. La portion barrière permet d'éviter que les structures environnantes soient détériorées lors de la gravure de la portion sacrificielle. Dans la suite, un premier mode de réalisation prévoit une portion sacrificielle en un matériau diélectrique, par exemple en oxyde de silicium ou en nitrure de silicium, et une portion barrière en un matériau métallique, par exemple en aluminium. Un deuxième mode de réalisation prévoit au contraire une portion sacrificielle en un matériau métallique et une portion barrière en un matériau diélectrique.

Dans les exemples suivants, le dispositif est un dispositif optoélectronique, de préférence une diode électroluminescente (LED). Il est entendu que le procédé convient parfaitement à la fabrication d'autres dispositifs, par exemple des lasers ou des cellules photovoltaïques, ou encore des dispositifs microélectroniques ou des microsystèmes électromécaniques (MEMS).

Comme illustré à la figure 2A, une première étape du procédé consiste à fournir des structures 3D, ici des nanofils 2 semiconducteurs, sur un substrat 3 porteur. Ces nanofils 2 sont de préférence à base de matériaux III-V, par exemple à base de GaN, d'AlGaN, d'InGaN. Ils peuvent être alternativement à base de matériaux II-VI, par exemple à base de ZnO, ZnSe, ou encore à base de matériaux IV-IV, par exemple à base de Si, de SiGe.

Les nanofils 2 s'étendent de préférence longitudinalement selon z. Ils peuvent présenter une hauteur comprise entre quelques dizaines de nanomètres et plusieurs micromètres, par exemple entre 100 nm et 20 µm. Ils peuvent présenter différentes formes, en section dans le plan xy. Les nanofils 2 à base de GaN présentent typiquement une section sensiblement hexagonale. La dimension maximale des nanofils 2 dans le plan xy, par exemple le diamètre, peut être comprise entre quelques dizaines de nanomètres et plusieurs micromètres, par exemple entre 50 nm et 5 µm. Ils présentent un sommet 201 et une base 200. Leur base 200 prend appui sur le substrat 3. Ils sont de préférence sensiblement parallèles entre eux et régulièrement distribués sur le substrat 3. Ils peuvent être encapsulés par une couche d'encapsulation 24, par exemple en un matériau diélectrique tel que du dioxyde de silicium ou du nitrure de silicium. Cela permet de protéger les nanofils 2. Cela permet également d'améliorer la tenue mécanique du réseau de nanofils 2 sur le substrat 3.

Le substrat 3 présente typiquement une surface 300 supportant la base 200 des nanofils 2. Cette surface 300 s'étend principalement selon un plan basal xy. Elle peut être plane ou faiblement structurée. De façon connue, le substrat 3 peut comprendre une couche de support massive (non illustrée), une couche de nucléation 31, une ou plusieurs couche(s) de masquage 32, 33. Selon cet exemple, les nanofils 2 sont typiquement obtenus par croissance à partir de la couche de nucléation 31, au travers d'ouvertures de la couche de masquage 32 et/ou de la couche antireflets 33.

La couche de support massive sous-jacente aux couches 31, 32, 33 peut être retirée en partie ou totalement. De façon connue, un substrat de manipulation (non illustré) est assemblé du côté C2, en « face avant », du dispositif 1. La couche de support massive est alors retirée mécaniquement, par rognage, et/ou chimiquement, par gravure, et/ou au moyen d'un laser. Cela permet d'exposer la couche de nucléation 31 du côté C1, en « face arrière », du dispositif 1. La couche de nucléation 31 peut éventuellement être retirée également.

Selon un premier mode de réalisation, une première couche 11 métallique, par exemple en aluminium, est déposée en face arrière sur la couche de nucléation 31, comme illustré à la figure 2B. Cette première couche 11 métallique correspond à un premier niveau M1 de métal.

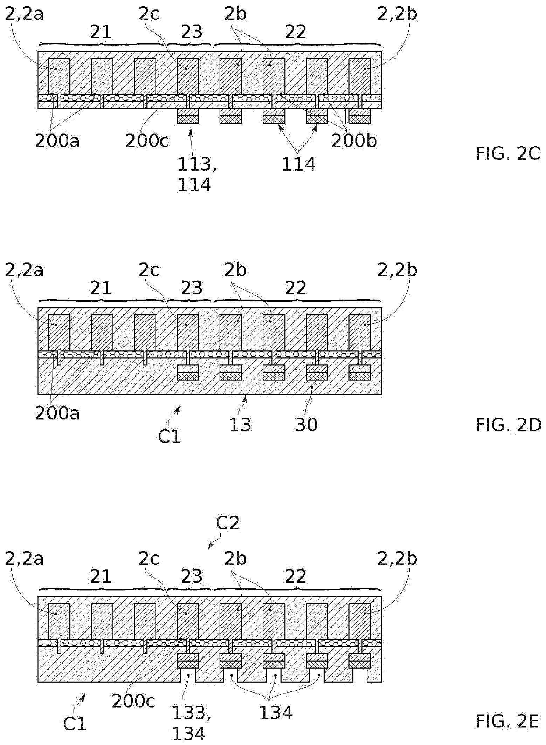

Comme illustré à la figure 2C, la première couche 11 métallique et/ou la couche de nucléation 31 sont structurées, typiquement par gravure anisotrope à partir de la face arrière, de façon à retirer totalement les portions des couches 11, 31 situées sous les bases 200a d'un premier ensemble 21 de nanofils 2a. Ce premier niveau de métal M1 permet typiquement de former des plots 114 de contact individuels sous les bases 200b d'un deuxième ensemble 22 de nanofils 2b. Selon une possibilité préférée, la gravure anisotrope est configurée pour former une ligne 113 de métal continue sous les bases 200c d'un troisième ensemble 23 de nanofils 2c en bordure immédiate du premier ensemble 21. Cette ligne 113 de métal permet de séparer, en projection dans le plan xy, le premier ensemble 21 du deuxième ensemble 22. Alternativement, une ligne 113 discontinue ou des plots 114 peuvent être formés sous les bases 200c des nanofils 2c.

Les nanofils 2a du premier ensemble 21 sont destinés à être retirés à l'issue du procédé. Les nanofils 2b du deuxième ensemble 22 sont typiquement des nanofils actifs destinés à émettre de la lumière. Les nanofils 2c du troisième ensemble 23 sont typiquement des nanofils inactifs, généralement appelés « dummy ».

Comme illustré à la figure 2D, une couche 13 diélectrique, par exemple en SiO2, est ensuite déposée en face arrière de manière à former une portion sacrificielle 30 sous le premier ensemble 21 de nanofils 2a. Cette couche 13 enrobe de préférence les plots 114 de contacts et/ou la ligne 113. Cela permet d'assurer la tenue mécanique des plots 114 et/ou de la ligne 113 tout en les isolant électriquement entre eux.

Comme illustré à la figure 2E, une gravure de la couche 13 diélectrique, typiquement par gravure anisotrope à partir de la face arrière, est effectuée de façon à former des vias 134 sous les plots 114 de contact individuels. Selon une possibilité préférée, cette gravure est configurée pour former une tranchée 133 continue sous la ligne 113 de métal. Alternativement, une tranchée 133 discontinue ou des vias 134 peuvent être formés sous les plots 114 de contacts et/ou la ligne 113 situés sous les bases 200c des nanofils 2c.

Comme illustré à la figure 2F, la tranchée 133 et/ou les vias 134 sont ensuite remplis de métal. Ce remplissage peut se faire directement lors du dépôt en face arrière d'une deuxième couche 12 métallique, par exemple en aluminium, sur la couche 13 diélectrique. Alternativement, le remplissage et le dépôt de la deuxième couche métallique peuvent se faire indépendamment. La deuxième couche métallique vient en affleurement de la tranchée 133 et/ou des vias 134 remplis de métal. Cette deuxième couche 12 métallique s'étend selon un plan xy et est structurée de façon à former un deuxième niveau M2 de métal. Ce niveau de métal M2 est typiquement destiné à connecter les nanofils 2b formant des sous-pixels d'une même couleur. Ainsi, il est entendu que ce niveau de métal M2 comprend différentes pistes connectant différents sous-pixels ou nanofils 2b, bien que cet aspect ne soit pas visible sur les figures en coupe transverse selon yz. La deuxième couche 12 métallique est continue sous la portion sacrificielle 30. Une portion barrière 50 métallique est ainsi formée sous et en bordure de la portion sacrificielle 30 diélectrique.

La portion barrière 50 a pour fonction de protéger les régions environnantes lors de la gravure ultérieure de la portion sacrificielle 30. Elle permet typiquement de limiter une expansion de cette gravure en dehors de la portion sacrificielle 30. Une telle gravure est ainsi confinée au niveau de la portion sacrificielle 30.

Dans cet exemple, la tranchée 133, ou les vias 134 remplis de métal et situés sous les bases 200c des nanofils 2c, forment, en combinaison avec la ligne 113 ou avec les plots 114 de contacts situés sous les bases 200c des nanofils 2c, une paroi latérale 52 de la portion barrière 50 métallique. Cette paroi latérale 52 limite ou évite une expansion latérale de la gravure, i.e. principalement selon des directions du plan xy, en bordure de la portion sacrificielle. Cette paroi latérale 52 est de préférence continue. Cela stoppe plus efficacement l'expansion latérale de la gravure, en particulier dans le cas d'une gravure humide. Alternativement, elle peut être ajourée ou crénelée. La paroi latérale peut présenter une épaisseur, prise dans le plan xy, comprise entre 50 nm et 2 µm. Selon une possibilité, la paroi latérale 52 ne se situe pas à l'aplomb des nanofils 2c. Elle peut se situer entre les nanofils 2b et les nanofils 2a, en projection sur un plan xy.

Une partie de la deuxième couche 12 métallique s'étendant sous les premiers et troisième ensembles 21, 23 de nanofils 2a, 2c forme une paroi basale 51 de la portion barrière 50 métallique. Cette paroi basale 51 stoppe une expansion de la gravure selon la direction z, sous la portion sacrificielle. La paroi basale peut présenter une épaisseur, prise selon z, comprise entre 50 nm et 2 µm.

Selon une variante illustrée aux figures 2G, 2H, des motifs 301 sont formés dans la portion sacrificielle 30, à partir de la face arrière, puis remplis au moins partiellement lors du dépôt de la deuxième couche 12 métallique. Des marques 120 d'alignement sont ainsi formées en saillie de la paroi basale 51 (figure 2H). Ces marques 120 d'alignement permettent typiquement de faciliter l'alignement de différents masques de lithographie lors d'étapes ultérieures, par exemple lors de la formation d'un module convertisseur de couleur tel que décrit dans la suite.

La deuxième couche 12 métallique peut ensuite être gravée de façon à former des plots 124 de contacts ou des pistes sous les vias 134 et/ou les plots 114 de contact. Cela permet de contacter collectivement ou individuellement les nanofils 2b actifs du deuxième ensemble 22. Cette gravure est de préférence configurée pour séparer la portion barrière 50 des plots de contact 124 (figure 2I).

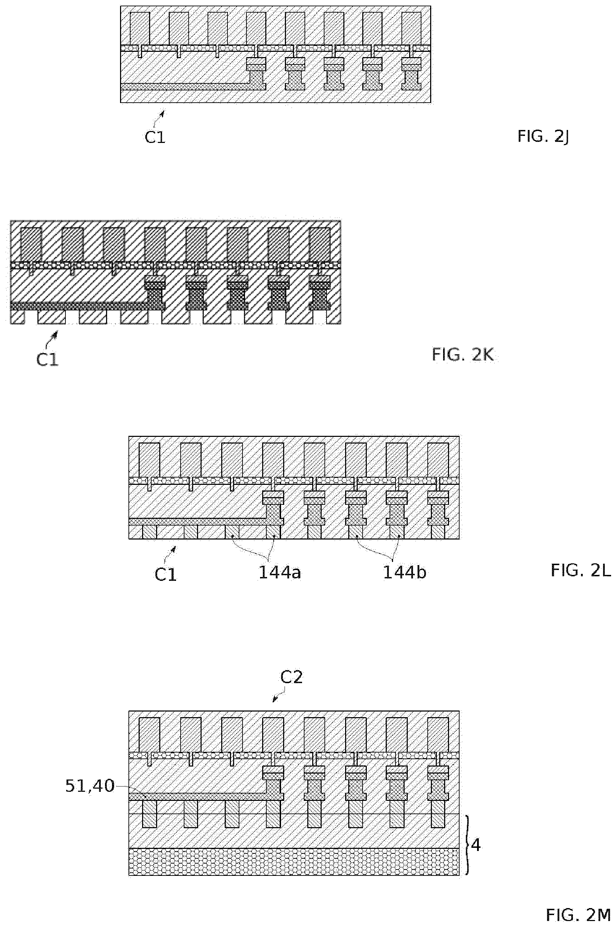

Comme illustré aux figures 2J, 2K, 2L, la face arrière C1 peut être façonnée et/ou préparée de façon à accueillir des plots de connexion 144a, 144b. Ces plots de connexion 144a, 144b sont typiquement en cuivre. Ils permettent de connecter, de façon connue, une électronique de pilotage 4 comme illustré à la figure 2M. En particulier, les plots de connexion 144a sont configurés pour contacter la portion barrière 50 métallique, typiquement au niveau de la paroi basale 51. Les plots de connexion 144b peuvent être configurés pour contacter les nanofils 2b actifs, par l'intermédiaire des plots 124 de contacts par exemple.

Il est entendu que d'autres niveaux de métaux et de vias ou de plots peuvent être formés entre le niveau M2 et les plots de connexion 144a, 144b.

Une électronique de pilotage 4 du dispositif à base de nanofils est de préférence assemblée en face arrière, par l'intermédiaire des plots de connexion 144a, 144b. Cette électronique 4 peut être typiquement une électronique à base de transistors CMOS (transistors Complémentaires Métal-Oxyde-Semiconducteur). Alternativement, elle peut être à base de transistors en couches minces TFT. Selon un exemple, les transistors TFT sont formés selon une technologie IGZO. La paroi basale 51 de la portion barrière 50 forme dès lors avantageusement un pad de contact 40 pour l'électronique 4. Ce pad de contact 40 est à ce stade enterré sous les nanofils 2a. Dans la suite, certaines étapes du procédé visent à dégager ce pad de contact 40 de façon à le rendre accessible depuis la face avant C2.

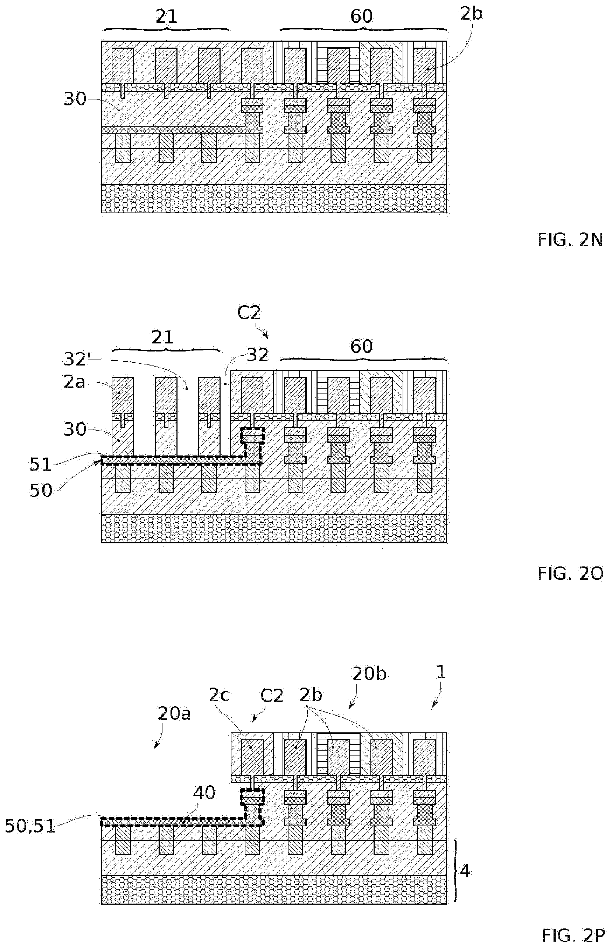

Selon une possibilité illustrée à la figure 2N, un module 60 convertisseur de couleur est formé au niveau des nanofils 2b du deuxième ensemble 22. De façon connue, un tel module 60 est configuré pour convertir une lumière émise par les nanofils 2b présentant une première longueur d'onde, en lumière présentant une ou plusieurs longueurs d'onde différentes, typiquement des première, deuxième et troisième longueurs d'onde correspondant aux couleurs bleu (B), vert (V) et rouge (R). Cela permet de former des sous-pixels RVB d'un pixel d'un écran d'affichage par exemple, à partir des nanofils 2b actifs. Un tel module 60 est typiquement formé par dépôt localisé de différentes nanoparticules sur différents sous-ensembles de nanofils 2b destinés à former les sous-pixels. Le dépôt localisé peut être facilité par la présence de marques d'alignement dans le dispositif, telles qu'illustrées à la figure 2H par exemple. Alternativement, le module 60 peut être formé selon d'autres techniques de conversion de couleur. Il peut par exemple comprendre des filtres colorés.

Les figures 2O et 2P illustrent l'enlèvement des nanofils 2a du premier ensemble 21. Une tranchée d'accès 32 est d'abord formée en pourtour du premier ensemble 21. Cette tranchée d'accès 32 présente un contour continu en projection dans le plan xy. Cela permet de détourer le premier ensemble 21, et de le séparer du deuxième ensemble 22. La tranchée d'accès 32 est configurée pour déboucher au niveau de la portion sacrificielle 30. Elle peut éventuellement s'étendre jusqu'à la paroi basale 51 de la portion barrière 50, comme illustré à la figure 2O. Une telle tranchée d'accès 32 est typiquement formée par gravure anisotrope selon z à partir de la face avant C2. Elle présente de préférence une sélectivité de gravure S_{30:50} du matériau diélectrique de la portion sacrificielle 30 vis-à-vis du matériau métallique de la portion barrière 50 telle que S_{30:50} > 5:1. Cela permet de stopper la gravure de la tranchée d'accès 32 sur la portion barrière 50 tout en préservant l'état de surface de cette portion barrière 50. Cela est notamment avantageux lorsque la portion barrière 50 est destinée à former directement le pad de contact 40. L'accès à la portion sacrificielle 30 se fait au travers de la tranchée d'accès 32. D'autres vias ou tranchées 32' peuvent être formés de manière à améliorer ou faciliter l'accès à la portion sacrificielle 30. Ces vias ou tranchées 32' peuvent être réalisés de la même façon que la tranchée d'accès 32, par la même gravure anisotrope. Ces vias ou tranchées 32' supplémentaires sont de préférence formés entre les nanofils 2a à retirer. Il n'est ainsi pas nécessaire de graver les nanofils 2a.

La portion sacrificielle 30 est ensuite gravée par gravure isotrope de façon à retirer les nanofils 2a (figure 2P). La gravure isotrope permet de désolidariser les nanofils 2a du substrat. Les nanofils 2a sont ensuite évacués facilement. Cela limite ou supprime avantageusement un recours à une action mécanique pour éliminer les nanofils 2a. La gravure isotrope est ici configurée pour graver le matériau diélectrique de la portion sacrificielle 30 sélectivement au matériau métallique de la portion barrière 50, avec de préférence une sélectivité S_{30:50} > 5:1. Cela permet de retirer toute la portion sacrificielle tout en conservant la portion barrière 50, comme illustré à la figure 2P. La paroi basale 51 de la portion barrière 50 est dès lors exposée du côté de la face avant C2. Elle forme avantageusement un pad de contact 40 pour l'électronique de pilotage 4. Un dispositif 1 optoélectronique couplé à une électronique de pilotage 4, comprenant une zone 20a dépourvue de nanofils 2a et débouchant directement sur un pad de contact 40 de l'électronique de pilotage 4, et une zone 20b pourvue de nanofils 2b actifs, est réalisé. Dans cet exemple, le module convertisseur de couleur 60 est réalisé au niveau de la zone 20b avant enlèvement des nanofils 2a de la zone 20a.

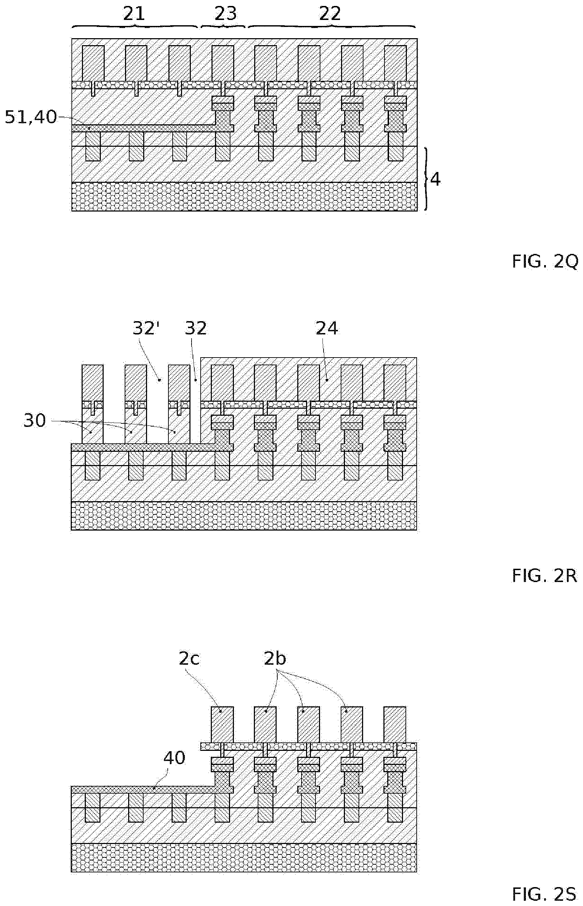

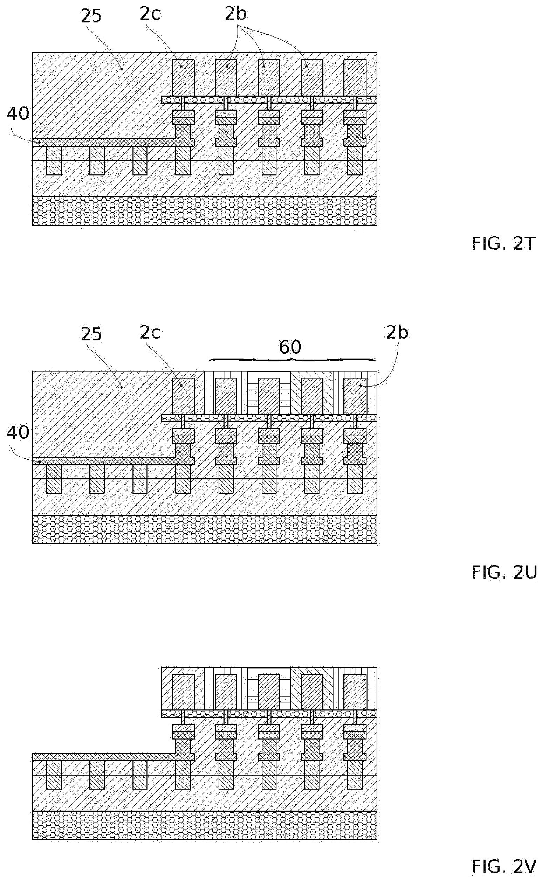

Selon une variante illustrée aux figures 2Q à 2V, ce module convertisseur de couleur 60 peut être réalisé après enlèvement des nanofils 2a de la zone 20a. En particulier, après assemblage de l'électronique de pilotage 4 (figure 2Q), la ou les tranchées d'accès 32, 32' sont formées (figure 2R). La portion sacrificielle 30 et la couche d'encapsulation 24 peuvent être ensuite éliminées via la gravure isotrope du matériau diélectrique (figure 2S), avant formation du module convertisseur de couleur 60. Selon une possibilité, la couche d'encapsulation 24 est conservée en vue de la formation du module convertisseur de couleur 60. Cela évite une étape de planarisation supplémentaire. Une couche de protection 25 est de préférence déposée sur le pad de contact 40 et les nanofils 2b, 2c (figure 2T). Le module convertisseur de couleur 60 est ensuite formé au niveau des nanofils 2b (figure 2U). La couche de protection 25 peut ensuite être retirée localement de manière à dégager le pad de contact 40 (figure 2V). Le repérage du pad de contact 40, et éventuellement des marques d'alignement 120 liées au pad de contact, est facilité par un enlèvement des nanofils 2a préalable à la formation du module convertisseur de couleur 60. Cela permet d'améliorer la précision d'alignement des différents masques de lithographie mis en oeuvre lors de la formation du module convertisseur de couleur.

Un deuxième mode de réalisation selon l'invention est illustré par les figures 3A à 3R. Seules les caractéristiques distinctes du premier mode de réalisation sont décrites ci-après, les autres caractéristiques non décrites étant réputées identiques à celles du premier mode de réalisation.

Après fourniture du substrat 3 portant les nanofils 2 semiconducteurs (figure 3A), une première couche 11 métallique, par exemple en aluminium, est déposée en face arrière C1 du substrat 3, comme illustré à la figure 3B. Cette première couche 11 métallique correspond au premier niveau M1 de métal.

Comme illustré à la figure 3C, la première couche 11 métallique et/ou la couche de nucléation 31 sont structurées, typiquement par gravure anisotrope à partir de la face arrière C1, de façon à former une portion sacrificielle 30 métallique sous les bases 200a du premier ensemble 21 de nanofils 2a. Ce premier niveau de métal M1 permet également de former des plots 114 de contact individuels sous les bases 200b du deuxième ensemble 22 de nanofils 2b.

Comme illustré à la figure 3D, une couche 15 diélectrique, par exemple en SiO2, est ensuite déposée en face arrière de manière à former une portion barrière 50 diélectrique sous et en bordure de la portion sacrificielle 30 métallique. Cette couche 15 enrobe de préférence les plots 114 de contacts. Dans cet exemple, une partie de la couche 15 diélectrique située sous les bases 200c des nanofils 2c forme une paroi latérale 52 de la portion barrière 50 diélectrique. La paroi latérale peut présenter une épaisseur, prise dans le plan xy, comprise entre 100 nm et 2 µm.

Une autre partie de la couche 15 diélectrique s'étendant sous les premier et troisième ensembles 21, 23 de nanofils 2a, 2c forme une paroi basale 51 de la portion barrière 50 diélectrique. La paroi basale peut présenter une épaisseur, prise selon z, comprise entre 50 nm et 2 µm.

Des vias 134 remplis de métal sont ensuite formés sous les plots 114 de contact individuels, comme précédemment. Une deuxième couche 12 métallique, par exemple en aluminium, est ensuite déposée sur la paroi basale 51 de la portion barrière 50 diélectrique (figure 3E).

La deuxième couche 12 métallique peut ensuite être gravée de façon à former un pad de contact 40 sous la portion barrière 50. Selon une possibilité, d'autres structures, alternativement ou en combinaison avec le pad 40, peuvent être formées par cette gravure sous la portion barrière 50. Cette gravure permet par exemple de former des marques d'alignement sous la portion barrière 50. Cette gravure est de préférence configurée pour former des plots 124 de contacts sous les vias 134 et/ou les plots 114 de contact (figure 3F).

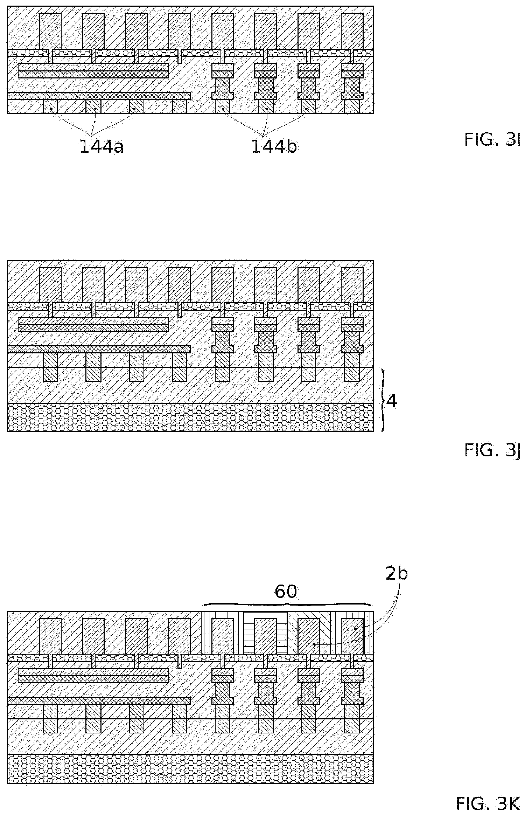

Tel qu'illustré aux figures 3G, 3H, 3I, la face arrière C1 peut être façonnée et/ou préparée de façon à accueillir des plots de connexion 144a, 144b, comme précédemment. Les plots de connexion 144a sont typiquement configurés pour contacter le pad de contact 40. Les plots de connexion 144b peuvent être configurés pour contacter les nanofils 2b actifs, par l'intermédiaire des plots 124 de contacts par exemple.

Une électronique de pilotage 4 du dispositif à base de nanofils est de préférence assemblée en face arrière, par l'intermédiaire des plots de connexion 144a, 144b (figure 3J).

Selon une possibilité illustrée à la figure 3K, un module 60 convertisseur de couleur est formé au niveau des nanofils 2b du deuxième ensemble 22, comme précédemment.

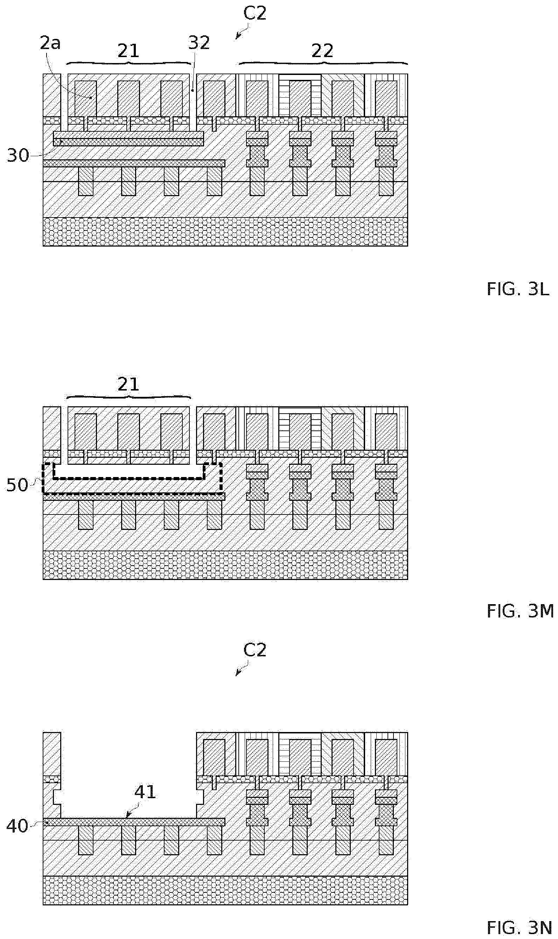

Les figures 3L et 3M illustrent l'enlèvement des nanofils 2a du premier ensemble 21. Une tranchée d'accès 32 est d'abord formée en pourtour du premier ensemble 21. Cette tranchée d'accès 32 présente un contour continu en projection dans le plan xy. Cela permet de détourer le premier ensemble 21, et de le séparer du deuxième ensemble 22. La tranchée d'accès 32 est configurée pour déboucher au niveau de la portion sacrificielle 30, comme illustré à la figure 3L. Une telle tranchée d'accès 32 est typiquement formée par gravure anisotrope selon z à partir de la face avant C2. Elle présente de préférence une sélectivité de gravure S_{30:50} du matériau métallique de la portion sacrificielle 30 vis-à-vis du matériau diélectrique de la portion barrière 50 telle que S_{30:50} > 5:1. L'accès à la portion sacrificielle 30 se fait au travers de la tranchée d'accès 32. D'autres vias ou tranchées peuvent être formés de manière à améliorer ou faciliter l'accès à la portion sacrificielle 30 (non illustré).

La portion sacrificielle 30 est ensuite gravée par gravure isotrope de façon à désolidariser les nanofils 2a du dispositif 1 (figure 3M). La gravure isotrope est ici configurée pour graver le matériau métallique de la portion sacrificielle 30 sélectivement au matériau diélectrique de la portion barrière 50, avec de préférence une sélectivité S_{30:50} > 5:1.

A l'issue du retrait du premier ensemble 21 de nanofils 2a, la portion barrière 50 diélectrique recouvre et protège le pad de contact 40. Une gravure de la portion barrière 50 diélectrique peut être effectuée de manière à exposer une face 41 du pad de contact 40, en face avant C2, comme illustré à la figure 3N.

Dans cet exemple, le module convertisseur de couleur 60 est réalisé avant enlèvement des nanofils 2a.

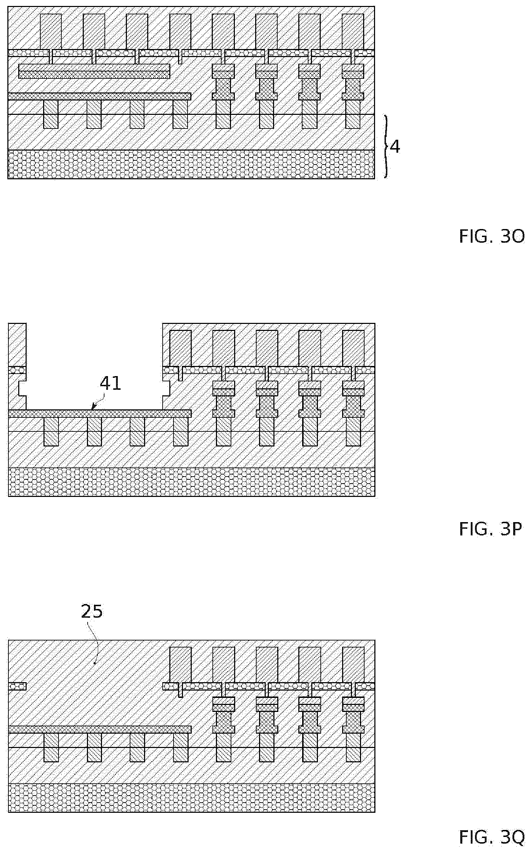

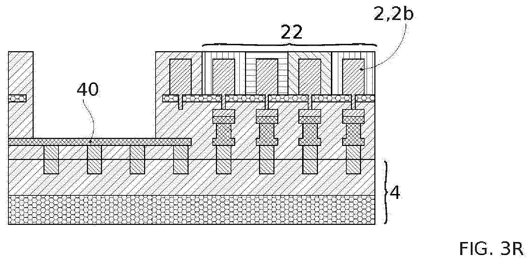

Selon une variante illustrée aux figures 3O à 3R, ce module convertisseur de couleur 60 peut être réalisé après enlèvement des nanofils 2a. En particulier, après assemblage de l'électronique de pilotage 4 (figure 3O), la portion sacrificielle 30 avec éventuellement la portion barrière 50 peuvent être gravées (figure 3P), avant formation du module convertisseur de couleur 60. Dès lors, une couche de protection 25 est de préférence déposée sur le pad de contact 40 (figure 3Q). Le module convertisseur de couleur 60 est ensuite formé au niveau des nanofils 2b, et la couche de protection 25 peut ensuite être retirée de manière à dégager le pad de contact 40, comme précédemment (figure 3R).

L'invention n'est pas limitée aux modes de réalisations précédemment décrits et s'étend à tous les modes de réalisation couverts par les revendications.

## Revendications

1. Procédé de fabrication d'un dispositif optoélectronique (1) comprenant au moins une première zone (20a) dépourvue de structures (2) semi-conductrices tridimensionnelles (3D) et au moins une deuxième zone (20b) pourvue de structures (2) semi-conductrices tridimensionnelles (3D), ledit procédé comprenant :
- Une fourniture d'un support (3) portant sur un plan (xy) basal une pluralité de structures (2) semi-conductrices tridimensionnelles, lesdites structures (2) présentant chacune une base (200) tournée vers un premier côté (C1) et un sommet (201) opposé à la base (200), tourné vers un deuxième côté (C2) opposé au premier côté (C1),
- Une formation, à partir du premier côté (C1), d'une portion sacrificielle (30) sous les bases (200a) d'un premier ensemble (21) de structures (2a) 3D de la pluralité de structures (2) semi-conductrices tridimensionnelles,
- Une formation d'une portion barrière (50) autour de la portion sacrificielle (30), ladite portion barrière (50) présentant une paroi basale (51) s'étendant sous la portion sacrificielle (30), et une paroi latérale (52) s'étendant en bordure de la portion sacrificielle (30), ladite paroi latérale (52) séparant, en projection selon une direction (z) normale au plan (xy) basal, le premier ensemble (21) de structures (2a) 3D d'un deuxième ensemble (22) de structures (2b) 3D de la pluralité de structures (2, 2a, 2b) semi-conductrices tridimensionnelles,
- Une formation, à partir du deuxième côté (C2), d'une tranchée d'accès (32) jusqu'à la portion sacrificielle (30), ladite tranchée d'accès (32) s'étendant de façon continue le long de la paroi latérale (52) de la portion barrière (50), en projection selon la direction (z) normale au plan (xy) basal,
- Une gravure de la portion sacrificielle (30) à partir de la tranchée d'accès (32),
- Un enlèvement du premier ensemble (21) de structures (2a) 3D, de sorte à définir l'au moins une première zone (20a) du dispositif.

2. Procédé selon la revendication précédente, dans lequel la gravure de la portion sacrificielle (30) présente une sélectivité de gravure S_{30:50} du matériau de la portion sacrificielle (30) vis-à-vis du matériau de la portion barrière (50) supérieure ou égale à 5:1.

3. Procédé selon l'une quelconque des revendications précédentes, dans lequel la formation de la tranchée d'accès (32) est effectuée par gravure anisotrope principalement dirigée selon la direction (z) normale au plan (xy) basal et dans lequel la gravure de la portion sacrificielle (30) est une gravure isotrope.

4. Procédé selon l'une quelconque des revendications précédentes, dans lequel la tranchée d'accès (32) est formée entre les structures (2a) du premier ensemble (21) et la paroi latérale (52) de la portion barrière (50), en projection selon la direction (z) normale au plan (xy) basal.

5. Procédé selon l'une quelconque des revendications précédentes, comprenant en outre, avant formation de la tranchée d'accès (32), une formation d'une zone de contact (40) sous les bases (200a) du premier ensemble (21) de structures (2a) 3D, ladite zone de contact (40) étant destinée à contacter une électronique de pilotage (4) du dispositif (1).

6. Procédé selon la revendication précédente, comprenant en outre, avant formation de la tranchée d'accès (32), (192), un assemblage d'une électronique de pilotage (4) du dispositif (1) au niveau de la zone de contact (40).

7. Procédé selon l'une quelconque des revendications précédentes, dans lequel la portion sacrificielle (30) est en un matériau métallique et la portion barrière (50) est en un matériau diélectrique.

8. Procédé selon la revendication précédente, comprenant :
- Un dépôt à partir du premier côté (C1) d'une première couche (11) métallique correspondant à un premier niveau (M1), puis
- Une gravure de ladite première couche (11) métallique à partir du premier côté (C1), configurée pour définir la portion sacrificielle (30) dans la première couche (11) métallique,
- Un dépôt à partir du premier côté (C1) d'une couche (15) diélectrique, configuré pour encapsuler la portion sacrificielle (30) et former la portion barrière (50).

9. Procédé selon les quatre revendications précédentes en combinaison, comprenant en outre :
- Avant assemblage de l'électronique de pilotage (4), un dépôt à partir du premier côté (C1) d'une deuxième couche (12) métallique correspondant à un deuxième niveau (M2), sur la couche diélectrique (15), puis
- Une gravure de ladite deuxième couche (12) métallique à partir du premier côté (C1) configurée pour définir la zone de contact (40) dans la deuxième couche (12) métallique, et
- Après assemblage de l'électronique de pilotage (4) et enlèvement du premier ensemble (21) de structures (2a) 3D, une gravure de la portion barrière (50) diélectrique, à partir du deuxième côté (C2), configurée pour exposer une face (41) de la zone de contact (40) ainsi définie, en regard du deuxième côté (C2).

10. Procédé selon l'une quelconque des revendications 1 à 6, dans lequel la portion sacrificielle (30) est en un matériau diélectrique et la portion barrière (50) est en un matériau métallique.

11. Procédé selon la revendication précédente, comprenant :
- Un dépôt à partir du premier côté (C1) d'une couche (13) diélectrique, de manière à ce qu'une partie de ladite couche (13) diélectrique située sous le premier ensemble (21) de structures (2a) 3D forme la portion sacrificielle (30),
- Une gravure de la couche (13) diélectrique en bordure du premier ensemble (21) de structures (2a) 3D, en projection selon une direction (z) normale au plan (xy) basal, suivie d'un dépôt métallique, configurés pour former la paroi latérale (52) de la portion barrière (50),
- Un dépôt à partir du premier côté (C1) d'une deuxième couche (12) métallique correspondant à un deuxième niveau (M2), sur la partie de la couche (13) diélectrique formant la portion sacrificielle (30) et en affleurement de la paroi latérale (52),
- Une gravure de ladite deuxième couche (12) métallique à partir du premier côté (C1), configurée pour définir la paroi basale (51) de la portion barrière (50) dans la deuxième couche (12) métallique et au contact de la paroi latérale (52).

12. Procédé selon la revendication précédente en combinaison avec l'une quelconque des revendications 5 ou 6, dans lequel la zone de contact (40) est formée directement par la paroi basale (51) de la portion barrière (50).

13. Procédé selon l'une quelconque des deux revendications précédentes, dans lequel la partie de la couche (13) diélectrique formant la portion sacrificielle (30) est structurée avant dépôt de la deuxième couche (12) métallique, de façon à former des marques (120) d'alignement en saillie de la paroi basale (51) de la portion barrière (50), lesdites marques (120) d'alignement permettant par exemple de faciliter une formation ultérieure d'un module (60) convertisseur de couleur.

14. Procédé selon l'une quelconque des revendications précédentes, comprenant en outre la formation d'un module (60) convertisseur de couleur au niveau des structures (2b) du deuxième ensemble (22).

15. Procédé selon la revendication précédente en combinaison avec l'une quelconque des revendications 5 ou 6, dans lequel la formation du module (60) convertisseur de couleur est effectuée après l'enlèvement du premier ensemble (21) de structures (2a) 3D, et dans lequel la zone de contact (40) est protégée par une couche de protection (25) durant la formation du module (60) convertisseur de couleur.

## Patentansprüche

1. Verfahren zum Herstellen einer optoelektronischen Vorrichtung (1), die mindestens einen ersten Bereich (20a), der nicht mit dreidimensionalen (3D) Halbleiterstrukturen (2) versehen ist, und mindestens einen zweiten Bereich (20b) umfasst, der mit dreidimensionalen (3D) Halbleiterstrukturen (2) versehen ist, wobei das Verfahren Folgendes umfasst:
- Bereitstellen eines Trägers (3), der auf einer Basisebene (xy) eine Vielzahl von dreidimensionalen Halbleiterstrukturen (2) trägt, wobei die Strukturen (2) jeweils eine Basis (200), die einer ersten Seite (C1) zugewandt ist, und eine Oberseite (201) aufweist, die der Basis (200) gegenüberliegt und einer zweiten, der ersten Seite (C1) gegenüberliegenden Seite (C2) zugewandt ist,
- Bilden, ausgehend von der ersten Seite (C1), eines Opferabschnitts (30) unter den Basen (200a) eines ersten Satzes (21) von 3D-Strukturen (2a) der Vielzahl von dreidimensionalen Halbleiterstrukturen (2),
- Bilden eines Barriereabschnitts (50) um den Opferabschnitt (30) herum, wobei der Barriereabschnitt (50) eine Basiswand (51), die sich unter dem Opferabschnitt (30) erstreckt, und eine Seitenwand (52) aufweist, die sich am Rand des Opferabschnitts (30) erstreckt, wobei die Seitenwand (52) in der Projektion in einer Richtung (z), die normal zur Basisebene (xy) verläuft, den ersten Satz (21) von 3D-Strukturen (2a) von einem zweiten Satz (22) von 3D-Strukturen (2b) der Vielzahl von dreidimensionalen Halbleiterstrukturen (2, 2a, 2b) trennt,
- Bilden eines Zugangsgrabens (32) ausgehend von der zweiten Seite (C2) bis zum Opferabschnitt (30), wobei sich der Zugangsgraben (32) kontinuierlich entlang der Seitenwand (52) des Barriereabschnitts (50) in der Projektion in der Richtung (z), die normal zur Basisebene (xy) verläuft, erstreckt,
- Ätzen des Opferabschnitts (30) aus dem Zugangsgraben (32),
- Entfernen des ersten Satzes (21) von 3D-Strukturen (2a), um den mindestens einen ersten Bereich (20a) der Vorrichtung zu definieren.

2. Verfahren nach dem vorhergehenden Anspruch, wobei das Ätzen des Opferabschnitts (30) eine Ätzselektivität S_{30:50} des Materials des Opferabschnitts (30) im Verhältnis zum Material des Barriereabschnitts (50) von größer gleich 5:1 aufweist.

3. Verfahren nach einem der vorhergehenden Ansprüche, wobei das Bilden des Zugangsgrabens (32) mittels anisotropen Ätzens durchgeführt wird, das hauptsächlich in der Richtung (z), die normal zur Basisebene (xy) verläuft, gerichtet ist, und wobei das Ätzen des Opferabschnitts (30) ein isotropes Ätzen ist.

4. Verfahren nach einem der vorhergehenden Ansprüche, wobei der Zugangsgraben (32) zwischen den Strukturen (2a) des ersten Satzes (21) und der Seitenwand (52) des Barriereabschnitts (50) in der Projektion in der Richtung (z), die normal zur Basisebene (xy) verläuft, gebildet wird.

5. Verfahren nach einem der vorhergehenden Ansprüche, das ferner vor dem Bilden des Zugangsgrabens (32) das Bilden eines Kontaktbereichs (40) unter den Basen (200a) des ersten Satzes (21) von 3D-Strukturen (2a) umfasst, wobei der Kontaktbereich (40) dazu bestimmt ist, eine Steuerungselektronik (4) der Vorrichtung (1) zu kontaktieren.

6. Verfahren nach dem vorhergehenden Anspruch, das ferner vor dem Bilden des Zugangsgrabens (32) das Montieren einer Steuerungselektronik (4) der Vorrichtung (1) am Kontaktbereich (40) umfasst.

7. Verfahren nach einem der vorhergehenden Ansprüche, wobei der Opferabschnitt (30) aus einem metallischen Material besteht und der Barriereabschnitt (50) aus einem dielektrischen Material besteht.

8. Verfahren nach dem vorhergehenden Anspruch, das Folgendes umfasst:
- Abscheiden einer ersten Metallschicht (11), die einer ersten Ebene (M1) entspricht, ausgehend von der ersten Seite (C1), dann
- Ätzen der ersten Metallschicht (11), die so konfiguriert ist, dass sie den Opferabschnitt (30) in der ersten Metallschicht (11) definiert, ausgehend von der ersten Seite (C1),
- Abscheiden einer dielektrischen Schicht (15), die so konfiguriert ist, dass sie den Opferabschnitt (30) einkapselt und den Barriereabschnitt (50) bildet, ausgehend von der ersten Seite (C1).

9. Verfahren nach den vier vorhergehenden Ansprüchen in Kombination, das ferner Folgendes umfasst:
- vor dem Montieren der Steuerungselektronik (4), Abscheiden einer zweiten Metallschicht (12), die einer zweiten Ebene (M2) entspricht, ausgehend von der ersten Seite (C1) auf der dielektrischen Schicht (15), dann
- Ätzen der zweiten Metallschicht (12), die so konfiguriert ist, dass sie den Kontaktbereich (40) in der zweiten Metallschicht (12) definiert, ausgehend von der ersten Seite (C1), und
- nach dem Montieren der Steuerungselektronik (4) und dem Entfernen des ersten Satzes (21) von 3D-Strukturen (2a), Ätzen des dielektrischen Barriereabschnitts (50), der so konfiguriert ist, dass er eine Fläche (41) des so definierten Kontaktbereichs (40), die der zweiten Seite (C2) zugewandt ist, freilegt, ausgehend von der zweiten Seite (C2).

10. Verfahren nach einem der Ansprüche 1 bis 6, wobei der Opferabschnitt (30) aus einem metallischen Material besteht und der Barriereabschnitt (50) aus einem dielektrischen Material besteht.

11. Verfahren nach dem vorhergehenden Anspruch, das Folgendes umfasst:
- Abscheiden einer dielektrischen Schicht (13) ausgehend von der ersten Seite (C1), so dass ein Teil der dielektrischen Schicht (13), der sich unter dem ersten Satz (21) von 3D-Strukturen (2a) befindet, den Opferabschnitt (30) bildet,
- Ätzen der dielektrischen Schicht (13) am Rand des ersten Satzes (21) von 3D-Strukturen (2a) in der Projektion in einer Richtung (z), die normal zur Basisebene (xy) verläuft, gefolgt von einer Metallabscheidung, die so konfiguriert sind, dass sie die Seitenwand (52) des Barriereabschnitts (50) bilden,
- Abscheiden einer zweiten Metallschicht (12), die einer zweiten Ebene (M2) entspricht, ausgehend von der ersten Seite (C1) auf dem Teil der dielektrischen Schicht (13), der den Opferabschnitt (30) bildet und bündig mit der Seitenwand (52) abschließt,
- Ätzen der zweiten Metallschicht (12), die so konfiguriert ist, dass sie die Basiswand (51) des Barriereabschnitts (50) in der zweiten Metallschicht (12) definiert und in Kontakt mit der Seitenwand (52) steht, ausgehend von der ersten Seite (C1).

12. Verfahren nach dem vorhergehenden Anspruch in Kombination mit einem der Ansprüche 5 oder 6, wobei der Kontaktbereich (40) direkt durch die Basiswand (51) des Barriereabschnitts (50) gebildet wird.

13. Verfahren nach einem der beiden vorhergehenden Ansprüche, wobei der Teil der dielektrischen Schicht (13), der den Opferabschnitt (30) bildet, vor dem Abscheiden der zweiten Metallschicht (12) strukturiert wird, um Ausrichtungsmarkierungen (120) zu bilden, die von der Basiswand (51) des Barriereabschnitts (50) hervorstehen, wobei die Ausrichtungsmarkierungen (120) zum Beispiel ermöglichen, ein nachträgliches Bilden eines Farbkonvertermoduls (60) zu erleichtern.

14. Verfahren nach einem der vorhergehenden Ansprüche, das ferner das Bilden eines Farbkonvertermoduls (60) an den Strukturen (2b) des zweiten Satzes (22) umfasst.

15. Verfahren nach dem vorhergehenden Anspruch in Kombination mit einem der Ansprüche 5 oder 6, wobei das Bilden des Farbkonvertermoduls (60) nach dem Entfernen des ersten Satzes (21) von 3D-Strukturen (2a) durchgeführt wird, und wobei der Kontaktbereich (40) während des Bildens des Farbkonvertermoduls (60) durch eine Schutzschicht (25) geschützt wird.

## Claims

1. A method for manufacturing an optoelectronic device (1) comprising at least one first area (20a) devoid of three-dimensional (3D) semiconductor structures (2) and at least one second area (20b) provided with three-dimensional (3D) semiconductor structures (2), said method comprising:
- A provision of a support (3) carrying on a basal plane (xy) a plurality of three-dimensional semiconductor structures (2), said structures (2) each having a base (200) facing a first side (C1) and a vertex (201) opposite the base (200), facing a second side (C2) opposite the first side (C1),
- A formation, from the first side (C1), of a sacrificial portion (30) under the bases (200a) of a first set (21) of 3D structures (2a) of the plurality of three-dimensional semiconductor structures (2),
- A formation of a barrier portion (50) around the sacrificial portion (30), said barrier portion (50) having a basal wall (51) extending under the sacrificial portion (30), and a side wall (52) extending along the edge of the sacrificial portion (30), said side wall (52) separating, in projection in a direction (z) normal to the basal plane (xy), the first set (21) of 3D structures (2a) from a second set (22) of 3D structures (2b) of the plurality of three-dimensional semiconductor structures (2, 2a, 2b),
- A formation, from the second side (C2), of an access trench (32) up to the sacrificial portion (30), said access trench (32) extending continuously along the side wall (52) of the barrier portion (50), in projection in the direction (z) normal to the basal plane (xy),
- An etching of the sacrificial portion (30) from the access trench (32),
- A removal of the first set (21) of 3D structures (2a), so as to define at least one first area (20a) of the device.

2. The method according to the preceding claim, wherein the etching of the sacrificial portion (30) has an etching selectivity S_{30:50} of the material of the sacrificial portion (30) with respect to the material of the upper barrier portion (50) or equal to 5:1.

3. The method according to any one of the preceding claims, wherein the formation of the access trench (32) is carried out by anisotropic etching mainly directed in the direction (z) normal to the basal plane (xy) and wherein the etching of the sacrificial portion (30) is an isotropic etching.

4. The method according to any one of the preceding claims, wherein the access trench (32) is formed between the structures (2a) of the first set (21) and the side wall (52) of the barrier portion (50), in projection in the direction (z) normal to the basal plane (xy).

5. The method according to any one of the preceding claims, further comprising, before forming the access trench (32), forming a contact area (40) under the bases (200a) of the first set (21) of 3D structures (2a), said contact area (40) being intended to contact control electronics (4) of the device (1).

6. The method according to the preceding claim, further comprising, before forming the access trench (32), an assembly of control electronics (4) of the device (1) at the contact area (40).

7. The method according to any one of the preceding claims, wherein the sacrificial portion (30) is made of a metal material and the barrier portion (50) is made of a dielectric material.

8. The method according to the preceding claim, comprising:
- A deposition from the first side (C1) of a first metal layer (11) corresponding to a first level (M1), then
- An etching of said first metal layer (11) from the first side (C1), configured to define the sacrificial portion (30) in the first metal layer (11),
- A deposition from the first side (C1) of a dielectric layer (15), configured to encapsulate the sacrificial portion (30) and form the barrier portion (50).

9. The method according to the four preceding claims in combination, further comprising:
- Before assembly of the control electronics (4), a deposition from the first side (C1) of a second metal layer (12) corresponding to a second level (M2), on the dielectric layer (15), then
- An etching of said second metal layer (12) from the first side (C1) configured to define the contact area (40) in the second metal layer (12), and
- After assembly of the control electronics (4) and removal of the first set (21) of 3D structures (2a), an etching of the dielectric barrier portion (50), from the second side (C2), configured to expose a face (41) of the contact area (40) thus defined, facing the second side (C2).

10. The method according to any one of claims 1 to 6, wherein the sacrificial portion (30) is made of a dielectric material and the barrier portion (50) is made of a metal material.

11. The method according to the preceding claim, comprising:
- A deposition from the first side (C1) of a dielectric layer (13), so that a part of said dielectric layer (13) located under the first set (21) of 3D structures (2a) forms the sacrificial portion (30),
- An etching of the dielectric layer (13) at the edge of the first set (21) of 3D structures (2a), in projection in a direction (z) normal to the basal plane (xy), followed by a metal deposition, configured to form the side wall (52) of the barrier portion (50),
- A deposition from the first side (C1) of a second metal layer (12) corresponding to a second level (M2), on the part of the dielectric layer (13) forming the sacrificial portion (30) and flush with the side wall (52),
- An etching of said second metal layer (12) from the first side (C1), configured to define the basal wall (51) of the barrier portion (50) in the second metal layer (12) and in contact with the side wall (52).

12. The method according to the preceding claim as combined with any one of claims 5 or 6, wherein the contact area (40) is formed directly by the basal wall (51) of the barrier portion (50).

13. The method according to any one of the two preceding claims, wherein the part of the dielectric layer (13) forming the sacrificial portion (30) is structured before deposition of the second metal layer (12), so as to form alignment marks (120) projecting from the basal wall (51) of the barrier portion (50), said alignment marks (120) allowing, for example, to facilitate subsequent formation of a colour converter module (60).

14. The method according to any one of the preceding claims, further comprising the formation of a colour converter module (60) at the structures (2b) of the second set (22).

15. The method according to the preceding claim as combined with any one of claims 5 or 6, wherein the formation of the colour converter module (60) is carried out after the removal of the first set (21) of 3D structures (2a), and wherein the contact area (40) is protected by a protective layer (25) during the formation of the colour converter module (60).
